Europäisches Patentamt

**European Patent Office**

**Office européen des brevets**

(19)

(11) Publication number: **0 028 454**
**B1**

## EUROPEAN PATENT SPECIFICATION

(12)

(45) Date of publication of patent specification: **04.04.84**

(21) Application number: **80303299.4**

(22) Date of filing: **19.09.80**

(51) Int. Cl.³: **G 01 R 19/22, H 03 D 1/18, H 02 M 7/217**

(54) **Full wave rectifier.**

(30) Priority: **25.09.79 JP 122074/79**

(43) Date of publication of application:
**13.05.81 Bulletin 81/19**

(45) Publication of the grant of the patent:
**04.04.84 Bulletin 84/14**

(84) Designated Contracting States:
**DE FR GB**

(56) References cited:
**DE - B - 2 527 658**
**US - A - 3 958 170**

**PROCEEDINGS OF THE IEEE, Vol. 67, No. 4, April 1979, S. POOKAIYAUDOM et al. "A Single-Transistor Full-Wave Rectifier" pages 687 and 689**
**ELECTRONIC ENGINEERING, Vol. 49, No. 598, October 1977, J. HAWKE "Low Offset Peak Detector Circuit Uses Transistors" page 23**

(73) Proprietor: **TOKYO SHIBAURA DENKI KABUSHIKI KAISHA**
**72, Horikawa-cho Saiwai-ku**
**Kawasaki-shi Kanagawa-ken 210 (JP)**

(72) Inventor: **Nagano, Katsumi**
**Takamura-danchi 18-606gou 203, Takamura**
**Hiratsuka-shi Hiratsuka-shi (JP)**

(74) Representative: **Kirk, Geoffrey Thomas et al,**
**BATCHELLOR, KIRK & EYLES 2 Pear Tree Court**
**Farringdon Road**
**London EC1R 0DS (GB)**

Courier Press, Leamington Spa, England.

Full wave rectifier

This invention relates to full wave rectifiers.

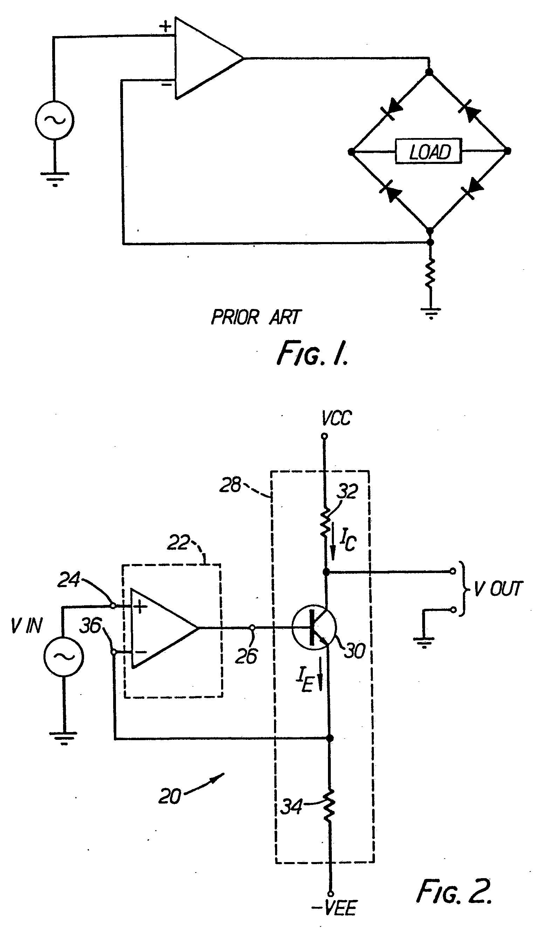

Electrical circuits employing diodes to rectify input signals are very well known. However, the forward voltage drop associated with a diode limits its ability to rectify low level signals. This rectification of low level signals can be improved if the diode is combined in a circuit with an operational amplifier. Figure 1 of the accompanying drawings shows diagrammatically a full wave precision rectifier which uses a diode bridge circuit and provides a current source drive for a floating load, such as a D'ArsonVal meter movement. Such rectifiers suffer from inadequate accuracy of rectification because of the presence of the diodes in the diode bridge circuit.

A full wave rectifier is known from U.S. Patent 3958170, in which a differential amplifier is powered from positive and negative supply lines and a transistor circuit includes a transistor and first and second resistors connected to the collector and the emitter of the transistor, respectively and to the first and second power sources, respectively; the base of the transistor is connected to the output of the differential amplifier and there is a feedback connection from the emitter of the transistor to the inverting input terminal amplifier. Although the rectified output signal is taken from the collector of the transistor, the A.C. signal is supplied to the inverting terminal and the non-inverting terminal is held at a potential intermediate the positive and negative supply lines.

A single transistor full-wave rectifier is disclosed on pages 687—689 of the Proceedings of the IEEE Vol. 67, No. 4, April 1979. In this article entitled "A Single Transistor Full Wave Rectifier", two closely matched resistors are connected to the emitter and collector of a transistor, respectively, and to positive and negative supply lines, respectively. An alternating signal is applied to the base of the transistor and a rectified output is obtained from the collector.

A differential amplifier having a current mirror collector load is shown in an article entitled "Low Offset Peak Detector Circuit Uses Transistors", to be found on page 23 of Electronic Engineering, Vol. 49, No. 598, October 1977.

It is an object of the present invention to provide a full wave rectifier which exhibits a higher degree of accuracy as compared with known rectifiers and which is capable of rectifying low input voltages.

According to the present invention, a full wave rectifier comprises first and second power sources of opposite polarity; a differential amplifier including a differential transistor pair and a constant current source determining the current through the differential transistor pair; a transistor circuit including a transistor and first and second resistors connected to the collector and the emitter of the transistor, respectively, and to the first and second power sources, respectively, the base of the transistor being connected to the output terminal of the differential amplifier, and the rectified output signal being provided at the collector of the transistor; and a feedback connection from the emitter of the transistor to the inverting input terminal of the differential amplifier, and is characterised in that the input signal to be rectified is applied to the non-inverting input terminal of the differential amplifier; and the differential amplifier comprises a current mirror as a load for the differential transistor pair.

The current mirror may be constituted by a pair of base coupled transistors, each having its emitter connected to the first power source, the collector of one of the transistors being connected to its base and also to the collector of one transistor of the differential transistor pair, and the collector of the other transistor being connected to the collector of the other transistor of the differential transistor pair and also connected to the output terminal of the differential amplifier.

Furthermore, another embodiment of the current mirror comprises a pair of base coupled transistors, each having its emitter connected to the first power source, the collector of one of the transistors being connected to the collector of one transistor of the differential transistor pair and to the base of a further transistor, said further transistor having its emitter connected both to the base and the collector of the other transistor of said pair of base coupled transistors and having its collector connected to the collector of the other transistor of the differential transistor pair and also connected to the output terminal of the differential amplifier.

In order that the invention may be more readily understood, it will now be described, by way of example only, with reference to Figures 1 to 8 of the accompanying drawings in which:—

Figure 2 shows a full wave rectifier circuit according to the present invention,

Figure 3 shows a more detailed diagram of the circuit of Figure 2,

Figure 4 shows the input and output signal waveform of the circuit shown in Figure 3,

Figure 5 shows an alternate embodiment of the present invention,

Figure 6 shows the transfer of characteristics of the circuit shown in Figure 5,

Figure 7 shows the deviation characteristics of the circuit of Figure 5 expressed as a voltage, and

Figure 8 shows the same deviation characteristics expressed as a percentage.

Figure 2 shows a full wave rectifier 20 which includes an operation amplifier 22. Input $V_{in}$ is

applied to a non-inverting terminal 24 of the amplifier and an output of the operation amplifier 22 is delivered from a terminal 26. This terminal is connected to a transistor circuit 28 including an n-p-n transistor 30, and first and second resistors 32 and 34. Resistor 32 is connected between a first power source $V_{CC}$ and the collector of transistor 30. A second resistor 34 is connected between a second power source $-V_{EE}$ and the emitter of transistor 30. The emitter of transistor 30 is also connected to an inverting terminal 36 of operational amplifier 22. Connection of the emitter of transistor 30 to the inverting terminal 36 forms a negative feedback loop, and it causes the emitter voltage $V_E$ of transistor 30 to follow the input. Namely, operational amplifier 22 works as a comparator, which compares the input signal $V_{in}$ with the emitter voltage $V_E$ applied to the feedback terminal 36. The output signal $V_{out}$ of rectifier 20 is delivered from the collector of transistor 30.

The full wave rectifying characteristics of this circuit are described below.

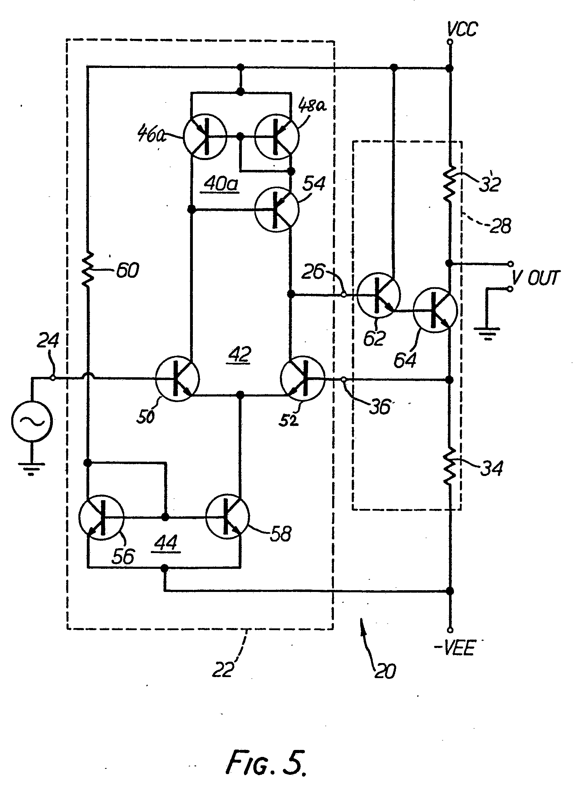

Consideration of the collector-emitter voltage $V_{CE}$ when $V_{in}>0$, such as between A and B in Figure 4, indicates that transistor 30 operates in a saturated state because the collector-emitter voltage $V_{CE}$ never takes a negative value as long as the emitter current $I_E$ flows. In saturation, $V_{BE}$ for transistor 30 is the same as the voltage on the base of transistor 30 except for a small DC offset. As a result of the feedback arrangement with amplifier 22, the voltage at terminal 26 tracks $V_{in}$ at terminal 24. Thus $V_{out}=V_{in}$ when $V_{in}>0$.

When input $V_{in}$ is negative, such as between B and C in Figure 4, emitter current $I_E$ flowing in the emitter of transistor 30 is expressed by the following equation:

$$I_E=(V_E-(-V_{EE}))/R_{34} \qquad (1)$$

where $R_{34}$ is the value of resistor 34.

Equation (1) may be modified as follows, because the emitter voltage $V_E$ of transistor 30 follows the input $V_{in}$:

$$I_E=(V_{in}+V_{EE})/R_{34} \qquad (2)$$

If the emitter current $I_E$ is assumed to be equal to the collector current $I_C$ of transistor 30, output $V_{out}$ is given by the following equation:

$$V_{out}=V_{CC}-R_{32}(V_{in}+V_{EE})/R_{34} \qquad (3)$$

where $R_{32}$ is the value of resistor 32.

If resistors 32 and 34 are identical ($R_{32}=R_{34}$) and the value voltages of power sources $V_{CC}$ and $V_{EE}$ have equal absolute value

$$(|V_{CC}|=|-V_{EE}|),$$

equation (3) may be rewritten as follows:

$$V_{out}=-V_{in}$$

when $V_{in}<0$.

As the collector-emitter voltage $V_{CE}$ has a positive value, equation (4) is valid when the input is in a negative half cycle.

Accordingly, the output $V_{out}$ of rectifier 20 has an absolute value of the input and is expressed as follows:

$$V_{out}=|V_{in}| \qquad (5)$$

A wave form of the output is shown in Figure 4(b).

Equation (2) is obtained under the assumption that the emitter current $I_E$ is equal to the collector current $I_C$. However, a more accurate equation is as follows:

$$V_{out}=V_{CC}-\alpha R_{32}(V_{in}+V_{EE})/R_{34} \qquad (6)$$

where $\alpha$ is the current amplification factor of transistor 30 when its base is grounded.

When resistors 32 and 34 are identical and the absolute value of each power source $V_{CE}$ and $-V_{EE}$ is the same, equation 6 may be rewritten as follows:

$$V_{out}=V_{CC}-\alpha(V_{in}+V_{EE}) \qquad (7)$$

$$=-\alpha V_{in}+(1-\alpha)V_{CC} \qquad (8)$$

According to equation (8), deviation between input $V_{in}$ and output $V_{out}$ mainly depends on the current amplification factor.

When the input signal is positive, deviation between $V_{in}$ and $V_{out}$ is caused by the saturated collector-emitter voltage $V_{CEsat}$. This deviation is more significant when the amplitude of input $V_{in}$ is small. Saturated collector-emitter voltage $V_{CEsat}$ is about 100 mV at 1 mA of collector current $I_C$ when rectifier 20 is in the form of an integrated circuit.

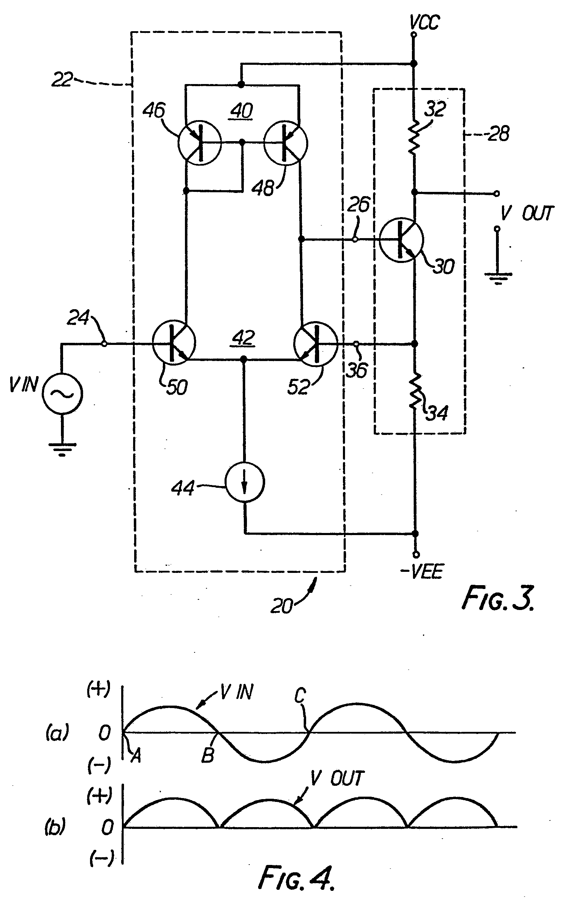

Figure 3 is a detailed circuit diagram of rectifier 20 illustrating the circuitry of amplifier 22. Operational amplifier 22 has a current mirror 40, a differential transistor pair 42 and a constant current source 44. Current mirror 40 consists of a pair of p-n-p transistors 46 and 48. The emitters of transistors 46 and 48 are connected to first power source $V_{CC}$. Transistor 46 operates as a diode in that its base and collector are interconnected. The bases of transistors 46 and 48 are connected to each other.

Differential pair 42 includes a pair of n-p-n transistors 50 and 52. The collectors of transistors 50 and 52 are connected to the collectors of transistors 46 and 48, respectively.

Constant current source 44 is provided between second power source $-V_{EE}$ and the emitters of transistors 50 and 52.

Non-inverting terminal 24 of operational amplifier 20 is connected to the base of transistor 50, while output terminal 26 of amplifier 22 is from the collector of transistor 52. The base of transistor 52, which is the inverting terminal 36 of operational amplifier 20, is connected to the emitter of transistor 30.

A detailed explanation of the operation of the circuit shown in Figure 3 is given below.

If emitter voltage $V_E$ of transistor 30 is higher than input $V_{in}$, the collector current of transistor 50 becomes smaller than the collector current of transistor 52. Having connected the collector of transistor 50 to the collector of transistor 46, which is one of the inputs of current mirror 40, current flowing out from the other input of current mirror 40, or the collector of transistor 48 is reduced. Due to the reduced collector current of transistor 48, the base current of transistor 30 is also reduced, and the emitter current $I_E$ and the emitter voltage $V_E$ of transistor 30 are then reduced until emitter voltage $V_E$ equals to $V_{in}$.

The inverse operation occurs when the emitter voltage $V_E$ of transistor 30 is lower than the input $V_{in}$.

Figure 5 shows a modification of the full wave rectifier of Figures 2 and 3.

Operational amplifier 22, in this embodiment, also consists of current mirror 40a, differential pair 42 and constant current source 44. Unlike the current mirror shown in Figure 3, current mirror 40a in this embodiment has three transistors 46a, 48a, and 54, which is called a Willson source. Constant current source 44 consists of a current mirror including a pair of transistors 56 and 58 and a resistor 60 connected between the first power source $V_{cc}$ and the collector of transistor 56. Transistor circuit 28 includes transistors 62 and 64 for increased current gain.

The operation of the circuit shown in Figure 5 is almost the same as the circuit shown in Figure 3, so that a detailed explanation is not necessary for one skilled in the art to make and use the invention.

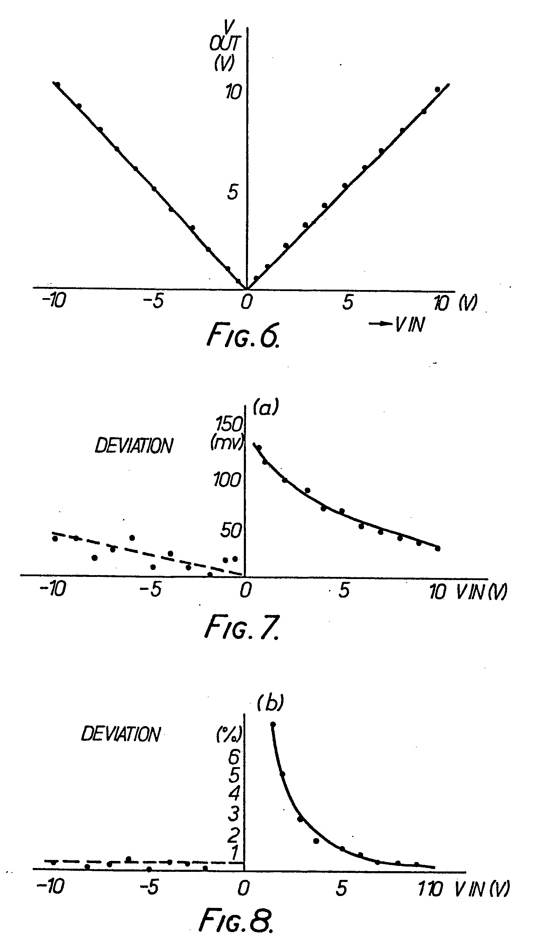

Figure 6 illustrates the transfer characteristics of rectifier 20 shown in Figure 5.

It can be seen from Figures 7 and 8 that the deviation between the input $V_{in}$ and the output $V_{out}$ is significant when the input $V_{in}$ is positive. The deviation is almost 40 mV or 0.4 percent for negative input values, while the deviation is gradually reduced as the input increases positively from 100 mV. The deviation is expressed in the following equation:

$$n = (|V_{in}| - |V_{out}|)/|V_{in}| \simeq 1 - \alpha \qquad (9)$$

As the current amplification factor $\alpha$ is more than 0.99, deviation n calculated by equation (9) is the same as that illustrated in Figures 7 and 8 when the input is negative. The reason why the deviation is reduced by increasing the output is the fact that the saturated collector voltage of transistor 64 decreases when the collector current decreases (and the collector current decreases as the input voltage increases).

## Claims

1. A full wave rectifier comprising first and second power sources, VCC, —VEE) of opposite polarity;

a differential amplifier (22) including a differential transistor pair (42); and a constant current source (44) determining the current through the differential transistor pair (42); a transistor circuit (28) including a transistor (30, 64) and first and second resistors (32, 34) connected to the collector and the emitter of the transistor, respectively, and to the first and second power sources, respectively, the base of the transistor being connected to the output terminal (26) of the differential amplifier, and the rectified output signal being provided at the collector of the transistor; and a feedback connection from the emitter of the transistor (30) to the inverting input terminal (36) of the differential amplifier (22), characterised in that the input signal to be rectified is applied to the non-inverting input terminal (24) of the differential amplifier (22); and the differential amplifier comprises a current mirror (40, 40a) as a load for the differential transistor pair (42).

2. A full wave rectifier as claimed in claim 1, characterised in that said current mirror (40) comprises a pair of base coupled transistors (46, 48), each having its emitter connected to the first power source, the collector of one of the transistors (46) being connected to its base and also to the collector of one transistor of the differential transistor pair (42), and the collector of the other transistor (48) being connected to the collector of the other transistor of the differential transistor pair (42) and also connected to the output terminal (26) of the differential amplifier (22).

3. A full wave rectifier as claimed in claim 1, characterised in that the current mirror (40a) comprises a pair of base coupled transistors (46a, 48a), each having its emitter connected to the first power source, the collector of one of the transistors (46a) being connected to the collector of one transistor (50) of the differential transistor pair (42) and to the base of a further transistor (54), said further transistor having its emitter connected both to the base and the collector of the other transistor (48a) of said pair of base coupled transistors and having its collector connected to the collector of the other transistor (52) of the differential transistor pair (42) and also connected to the output terminal (26) of the differential amplifier (22).

4. A full wave rectifier as claimed in any preceding claim, characterised in that said differential transistor pair (42) comprises a first transistor (50) having its base (24) constituting the input terminal of the differential amplifier (22), a second transistor (52) having its base constituting the inverting input terminal (36) of the differential amplifier (22), and with the constant current source (44) connected to the coupled emitters of the transistors (50, 52).

5. A full wave rectifier as claimed in any preceding claim, characterised in that the transistor circuit (28) has a further transistor (62) arranged with its emitter connected to the base of the said transistor (64) of the transistor circuit, its collector connected to the first power source and its base connected to the output terminal (26) of the differential amplifier (22).

## Patentansprüche

1. Vollweggleichrichter bestehend aus

einer ersten Stromquelle ($V_{CC}$) und einer zweiten Stromquelle ($-V_{EE}$) von einander entgegengesetzter Polarität;

aus einem Differentialverstärker (22) mit einem Differentialtransistorenpaar (42) und mit einer Konstantstromquelle (44) zum Festlegel des durch das Differentialtransistorenpaar (42) fließenden Stromes;

einer Transistorschaltung (28) mit einem Transistor (30, 64) sowie mit einem ersten und einem zweiten Widerstand (32, 34), die jeweils schaltungsmäßig zwischen dem Kollektor und dem Emitter des Transistors und der ersten und zweiten Stromquelle angeordnet sind, während die Basis des Transistors auf den Ausgangsanschluß des Differentialverstärkers geführt ist und das gleichgerichtete Ausgangssignal über den Kollektor des Transistors herausgeführt wird;

und aus einer Rückführungsschaltung zwischen dem Emitter des Transistors 30 und dem negativen Anschluß (36) des Differentialverstärkers (22). Der Vollweggleichrichter dadurch gekennzeichnet, daß

das Eingangssignal, das gleichgerichtet werden soll, dem positiven Anschluß (24) des Differentialverstärkers (22) aufgeschaltet wird;

der Differentialverstärker auch noch eine Stromspiegelungsschaltung (40, 40a) als Bürde für das Differentialtransformatorenpaar (42) aufweist.

2. Vollweggleichrichter nach Anspruch 1, dadurch gekennzeichnet, daß die Stromspiegelungsschaltung (40) aus den beiden basisgekoppelten Transistoren (46, 48) besteht, wobei die Emitteranschlüsse dieser Transistoren auf die erste Stromquelle geführt sind, wobei der Kollektoranschluß des Transistors (46) zum einen mit seinem Basisanschluß verbunden ist und zum anderen mit dem Kollektoranschluß von einem Transistor des Differentialtransistorenpaares (42), wobei weiterhin der Kollektoranschluß des anderen Transistors (48) einmal mit dem Kollektoranschluß des zum Differentialtransistorenpaar (42) gehörenden anderen Transistors geführt ist und zum anderen auf den Ausgangsanschluß (26) des Differentialverstärkers (22).

3. Vollweggleichrichter nach Anspruch 1, dadurch gekennzeichnet, daß daß die Stromspiegelungsschaltung (40a) aus den beiden basisgekoppelten Transistoren (46a, 48a) besteht, wobei deren Emitteranschlüsse auf die erste Stromquelle geführt sind, wobei der Kollektoranschluß des Transistors (46a) dem Kollektoranschluß des zum Differentialtransistorenpaar (42) gehörenden Transistors (50) verbunden ist und weiterhin auch noch mit dem Basisanschluß eines weiteren Transistors (54). Dieser weitere Transistor (54) ist mit seinem Emitteranschluß sowohl auf den Basisanschluß als auch auf den Kollektoranschluß des zu dem basisgekoppelten Transistorenpaar gehörenden anderen Transistors (48a) geführt und mit seinem Kollektoranschluß auf den zum Differentialtransistorenpaar (42) gehörenden anderen Transistors (52) und darüber hinaus auch noch auf den Ausgangsanschluß (26) des Differentialverstärkers (22).

4. Vollweggleichrichter nach irgendeinem der vorhergehenden Patentansprüche, dadurch gekennzeichnet, daß zu dem Differentialtransistorenpaar (42) ein erster Transistor (50) und ein zweiter Transistor (52) gehören, wobei der Basisanschluß (24) dieses ersten Transistors (50) gleichzeitig auch der positive Eingangsanschluß des Differentialverstärkers (22) ist, wobei weiterhin der Basisanschluß des vorerwähnten zweiten Transistors (52) gleichzeitig auch der negative Eingangsanschluß (36) des Differentialverstärkers (22) ist, wobei weiterhin auch noch die Konstantstromquelle (44) mit den miteinander verbundenen Emitteranschlüssen der Transistoren (50, 52) verbunden ist.

5. Vollweggleichrichter nach irgendeinem der vorhergehenden Patenansprüchen, dadurch gekennzeichnet, daß zu der Transistorschaltung (28) weiterhin auch noch ein anderer Transistor (62) gehört, dessen Emitteranschluß schaltungsmäßig auf den Basisanschluß des zur vorerwähnten Transistorschaltung gehörenden Transistors (64) geführt ist, dessen Kollektoranschluß mit der ersten Stromquelle verbunden ist und dessen Basisanschluß auf den Ausgangsschluß (26) des Differentialverstärkers (22) geführt ist.

## Revendications

1. Redresseur pleine onde qui comprend une première et une seconde sources d'énergie électrique ($V_{CC}$, $-V_{EE}$) ayant des polarités opposées, un amplificateur différentiel (22) incluant une paire de transistors différentielle (42) et une source de courant constante (44) déterminant le courant circulant dans la paire de transistors (42), un circuit (28) incluant un transistor (30, 64) et une première et une seconde résistances (32, 34) connectée respectivement au collecteur et à l'émetteur du transistor, et respectivement à la première et à la seconde sources d'énergie électrique, la base du transistor étant connectée à la borne de sortie (26) de l'amplificateur différentiel, et le signal de sortie redressé apparaîssant au collecteur du transistor et une connexion de retroaction entre l'émetteur du transistor (30) et la borne d'entrée inversante (36) de l'amplificateur différentiel (22), caractérisé en ce que le signal d'entrée devant être redressé est appliqué à la borne d'entrée non-inversante (24) de l'amplificateur différentiel (22) et, en ce que l'amplificateur différentiel comprend un circuit miroir (40, 40a) en tant que charge de la paire de transistors (42) de l'amplificateur différentiel.

2. Redresseur pleine oder selon la revendication 1, caractérisé en ce que ledit circuit miroir (40) comprend deux transistors (46, 48) dont les bases sont reliées, et dont l'emetteur est connecté à la première source d'énergie électrique, le collecteur de l'un des transistors (46) étant relié à sa base et aussi au collecteur de l'un des deux transistors de la paire (42) de l'amplificateur différentiel, tandis que le collecteur de l'autre transistor (48) est connecté au collecteur de l'autre transistor de la paire (42) de transistors de l'amplificateur différentiel, ainsi qu'à la borne de sortie (26) dudit amplificateur différentiel (22).

3. Redresseur pleine onde selon la revendication 1, caractérisé en ce que le circuit miroir (40a) comprend deux transistors (46a, 48a) reliée par la base, et dont l'émetteur est connecté à la première source d'énergie électrique, le collecteur de l'un des transistors (46a) étant connecté au collecteur de l'un des transistors (50) de la paire de transistors (42) de l'amplificateur différentiel et à la base d'un autre transistor (54), l'émetteur dudit autre transistor étant connecté à la fois à la base et au collecteur de l'autre transistor (48a) de ladite paire de transistors dont les bases sont reliées et dont le collecteur est connecté au collecteur de l'autre transistor (52) de la paire de transistors (42) de l'amplificateur différentiel et aussi à la borne de sortie (26) de l'amplificateur différentiel (22).

4. Redresseur pleine onde selon l'une quelconque des revendications précédentes, caractérisé en ce que ladite paire de transistors (42) de l'amplificateur différentiel comprend un premier transistor (50) dont la base (24) constitue la borne d'entrée de l'amplificateur différentiel (22), un second transistor (52) dont la base constitue la borne d'entrée inversante (36) de l'amplificateur différentiel (22), tandis que la source de courant constante (44) est connectée aux émetteurs couplés des transistors (50, 52).

5. Redresseur pleine onde selon l'une quelconque des revendications précédentes, caractérisé en ce que le circuit (28) possède un autre transistor (62) dont l'émetteur est connecté à la base dudit transistor (64) du circuit, son collecteur étant connecté à la première source d'énergie électrique, tandis que sa base est reliée à la borne de sortie (26) de l'amplificateur différentiel (22).

PRIOR ART

## FIG. 1.

## FIG. 2.

FIG. 3.

FIG. 4.

FIG. 5.

FIG.6.

FIG.7.

FIG.8.